Europäisches Patentamt

European Patent Office

Office européen des brevets

(19)

(11)  EP 0 586 730 B1

(12)  **EUROPÄISCHE PATENTSCHRIFT**

(45) Veröffentlichungstag und Bekanntmachung des
Hinweises auf die Patenterteilung:
**21.01.1998   Patentblatt 1998/04**

(51) Int Cl.$^6$: **H03F 3/45**

(21) Anmeldenummer: 92115432.4

(22) Anmeldetag: **09.09.1992**

(54) **Schaltungsanordnung zum Umformen eines symmetrischen gegenphasigen Eingangssignales in ein unsymmetrisches einphasiges Ausgangssignal**

Circuit arrangement for transforming a balanced input signal into an unbalanced output signal

Circuit pour transformer un signal d'entrée symmétrique biphasé en un signal de sortie asymmétrique monophasé

(84) Benannte Vertragsstaaten:
**DE ES FR GB IT**

(43) Veröffentlichungstag der Anmeldung:
**16.03.1994   Patentblatt 1994/11**

(73) Patentinhaber: **SIEMENS AKTIENGESELLSCHAFT**
**80333 München (DE)**

(72) Erfinder: **Heymann, Roland, Dipl.-Ing.**
**W-8029 Sauerlach (DE)**

(56) Entgegenhaltungen:
**EP-A- 0 459 070          DE-A- 2 249 859**
**US-A- 4 617 523**

- **ELECTRONIC DESIGN Bd. 33, Nr. 27, November 1985, HASBROUCK HEIGHTS, NEW JERSEY, USA Seiten 107 - 114 JERALD GRAEME 'Voltage gain is just one of the many uses for instrumentation amps'**
- **ELECTRONICS Bd. 61, Nr. 28, 28. April 1988, NEW YORK, US Seiten 125 - 132 JERALD GRAEME 'Instrumentation amps begin to challenge op amps'**

**Beschreibung**

Die Erfindung bezieht sich auf eine Schaltungsanordnung zum Umformen eines symmetrischen gegenphasigen Eingangssignales in ein unsymmetrisches einphasiges Ausgangssignal nach dem Oberbegriff des Patentanspruchs 1.

Eine solche Schaltungsanordnung ist in der Literaturstelle Electronic Design, Band 33, Nr.27, November 1985, Seiten 107 - 114, Jerald Graeme, "Voltage gain is just one of the many uses for instrumentation amps " beschrieben.

Solche Schaltungsanordnungen sind insbesondere dort notwendig, wo hochfrequente Signale verarbeitet werden müssen. Dies sind beispielsweise Tunerschaltungen, ZF-Schaltungen und Regelverstärker. Die bisher dafür bekanntgewordenen Schaltungen weisen eingangsseitig einen Differenzverstärker auf, an den das symmetrische gegenphasige Eingangssignal angelegt wird und bei dem mit Hilfe eines Stromspiegels im Differenzverstärker aus dem symmetrischen gegenphasigen Eingangssignal ein Gegenstromausgangssignal gebildet wird und dieses Gegenstromausgangssignal über einen Lastwiderstand an eine Referenzspannung geschaltet ist. Zusätzlich wird das Gegenstromausgangssignal einem Spannungsfolger zugeführt. Das unsymmetrische einphasige Ausgangssignal wird schließlich zwischen einer Ausgangsklemme des Spannungsfolgers und der Verbindung des Lastwiderstandes mit der Referenzspannung abgegriffen. Als Spannungsfolger wird in der Regel ein rückgekoppelter Operationsverstärker verwendet.

Eine andere Schaltungsanordnung zur Umsetrung eines symmetrischen Eingangssignals in ein unsymmetrisches Ausgangssignal ist beispielsweise in den integrierten Schaltkreisen TDA 5910 - einem Stereo-ZF-Verstärker - und dem TDA 593D - einem Video-ZF-Verstärker mit Demodulator - enthalten. Schaltungsbeschreibungen dieser integrierten Schaltungen sind beispielsweise im Siemens Datenbuch "ICs für die Unterhaltungselektronik" Bestellnr. B111-B6041-X-X-7400 auf den Seiten 577 bis 631 enthalten.

Es hat sich herausgestellt, daß diese Schaltungen hinsichtlich ihrer Ausgangskennlinie problematisch sind. Angestrebt wird bei solchen Schaltungsanordnungen normalerweise eine lineare Ausgangskennlinie, d. h. eine lineare Abhängigkeit vom symmetrisch gegenphasigen Eingangssignal zum unsymmetrischen einphasigen Ausgangssignal. Infolge des sogenannten Early-Effektes von Transistoren verursacht die bekannte Schaltungsanordnung jedoch eine nicht lineare Ausgangskennlinie und einen DC-Offset. Unter Early-Effekt versteht man dabei die Abhängigkeit des Verstärkungsfaktors von der Versorgungsspannung der Verstärkereinrichtung. Obwohl Transistoren einen Verstärkungsfaktor $\beta$ aufweisen, der idealerweise unabhängig von der Versorgungsspannung ist, stellt sich in der Praxis eine unerwünschte Abhängigkeit des Verstärkungsfaktcrs von der angelegten Versorgungsspannung ein, wodurch sich laufend eine Arbeitspunktverschiebung und damit eine unerwünschte Arbeitspunktmodulation des Verstärkers ergibt, wenn die Versorgungsspannung variiert. Darüberhinaus verursachen auch unvermeidbare Übersetzungsfehler, d. h. Fehler in der 8-Verstärkung der Transistoren in den Stromspiegeln des eingangsseitigen Differenzverstärkers einen Gleichspannungsoffset am Ausgang des Differenzverstärkers. Im übrigen verursachen auch Eingangsströme von nachfolgenden Pufferverstärkern einen Gleichspannungsoffset an diesem Ausgang.

Der Erfindung liegt deshalb die Aufgabe zugrunde, eine Schaltungsanordnung zum Umformen eines symmetrischen gegenphasigen Eingangssignals in ein unsymmetrisches einphasiges Ausgangssignal anzugeben, bei der eine gute lineare Abhängigkeit von Eingangssignal zu Ausgangssignal herrscht, damit die vorgenannten Nachteile nicht auftreten.

Diese Aufgabe wird durch eine Schaltungsanordnung mit den Merkmalen des Anspruchs 1 gelöst.

Bei unendlich guter Gleichtaktunterdrückung des Operationsverstärkers eliminiert die erfindungsgemäße Schaltungsanordnung folgende Fehler vollständig:

- die ersten und zweiten Ausgangsklemmen des Doppeldifferenzverstärkers werden durch den addierenden Ausgangsverstärker, also den Operationsverstärker gemäß der Erfindung, auf gleichem Potential gehalten, so daß durch den Early-Effekt verursachte Fehlströme als gleichgroße Gleichtaktströme auftreten und damit unterdrückt werden,

- Übersetzungsfehler, also Fehler in der B-Verstärkung in den Stromspiegeln der Doppeldifferenzverstärkeranordnung verursachen an der ersten und zweiten Ausgangsklemme des Doppeldifferenzverstärkers Gleichtaktfehlströme, die ebenfalls unterdrückt werden, und

- die Eingangsströme des als addierenden Strom-Spannungswandler geschalteten Operationsverstärkers verursachen an den ersten und zweiten Ausgangsklemmen des Doppeldifferenzverstärkers Gleichtaktfehlströme, die wiederum unterdrückt werden.

Darüberhinaus bietet die erfindungsgemäße Schaltungsanordnung den Vorteil, daß bei kleinen Versorgungsspannungen erheblich größere Aussteuerungsmöglichkeiten und damit größere Ausgangsspannungen an den Ausgangsanschlüssen der erfindungsgemäßen Schaltungsanordnung erreicht werden.

Die erfindungsgemäße Schaltungsanordnung zeichnet sich durch eine gute Aussteuerung bei kleinen Versorgungsspannungen aus und durch eine gute Kompensation einer unerwünschten Verstärkungsfaktormodulation in Abhängigkeit von der Versorgungsspannung.

Weiterbildungen der Erfindung sind Gegenstand der Unteransprüche.

Die Erfindung wird im folgenden anhand von zwei Figuren im Zusammenhang mit zwei Ausführungsbeispielen näher erläutert. Es zeigen:

FIG 1 eine erfindungsgemäße Schaltungsanordnung mit einem gepaarten Doppeldifferenzverstärker und einem nachfolgenden als addierenden Strom-Spannungswandler geschalteten Operationsverstärker und

FIG 2 eine Schaltungsanordnung nach FIG 1, mit einem im Detail dargestellten Operationsverstärker.

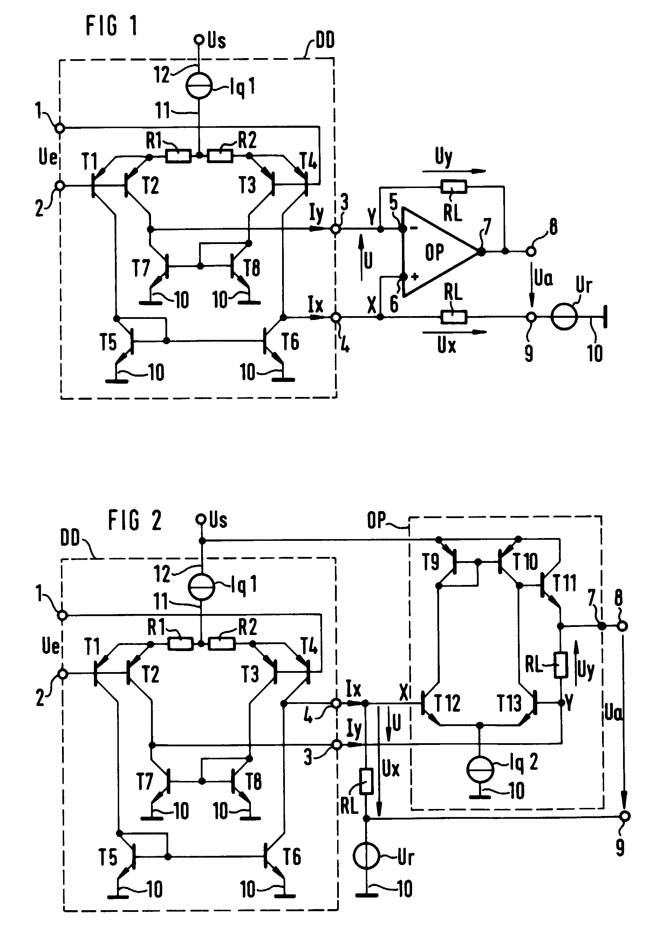

Das Ausführungsbeispiel in FIG 1 zeigt eine Schaltungsanordnung zum Umformen eines symmetrischen gegenphasigen Eingangssignales Ue in ein unsymmetrisches einphasiges Ausgangssignal Ua. Diese Schaltungsanordnung ist versehen mit:

- einem gepaarten Doppeldifferenzverstärker DD mit einer ersten und zweiten Eingangsklemme 1, 2 zum Anlegen des symmetrischen gegenphasigen Eingangssignales Ue und einer ersten und zweiten Ausgangsklemme 3, 4, an denen jeweils ein gegenphasiges Stromausgangssignal Ix, Iy abgreifbar ist;
- einem Lastwiderstand RL, der zwischen eine Referenzspannungsquelle Ur und die zweite Ausgangsklemme 4 des Doppeldifferenzverstärkers DD geschaltet ist;
- einen Operationsverstärker OP mit einem invertierenden Eingang 5, einem nicht invertierenden Eingang 6 sowie einem Ausgang 7, wobei der nicht invertierende Eingang 6 mit der zweiten Ausgangsklemme 4 des Doppeldifferenzverstärkers DD in Verbindung steht, und wobei der invertierende Eingang 5 einerseits mit der ersten Ausgangsklemme 3 des Doppeldifferenzverstärkers DD und andererseits über einen weiteren zum Lastwiderstand RL identischen Widerstand RL mit dem Ausgang 7 des Operationsverstärkers OP verbunden ist; und
- einen ersten und zweiten Ausgangsanschluß 8, 9, an denen das unsymmetrische einphasige Ausgangssignal Ua abgreifbar ist, wobei der erste Ausgangsanschluß 8 an den Ausgang 7 des Operationsverstärkers OP und der zweite Ausgangsanschluß 9 an eine Verbindung des Lastwiderstandes RL mit der Referenzspannungsquelle Ur angeschlossen ist.

Der in FIG 1 dargestellte gepaarte Doppeldifferenzverstärker DD weist im einzelnen auf:

- einen ersten Differenzverstärker mit einem ersten und einem vierten pnp-Transistor T1, T4 mit jeweils einem Emitteranschluß, Basisanschluß und Kollektoranschluß, deren Basisanschlüsse jeweils mit einer der Eingangsklemmen 1, 2 verbunden sind, deren Emitteranschlüsse jeweils über einen ersten und zweiten Widerstand R1, R2 mit einer Klemme 11 einer ersten Stromquelle Iq1 verbunden sind, deren andere Klemme 12 an eine Versorgungsspannung Us geschaltet ist, und deren Kollektoranschlüsse über eine erste Stromspiegelschaltung, bestehend aus einem fünften und sechsten Transistor T5, T6 an Bezugspotential 10 geschaltet sind;

- einem zweiten Differenzverstärker mit einem zweiten und dritten pnp-Transistor T2, T3 mit jeweils einem Emitteranschluß, Basisanschluß und Kollektoranschluß, deren Basisanschlüsse jeweils mit einer der Eingangsklemmen 1, 2 verbunden sind, deren Emitteranschlüsse mit jeweils einem der Emitteranschlüsse des ersten und vierten pnp-Transistors T1, T4 des ersten Differenzverstärkers verbunden sind, und deren Kollektoranschlüsse über eine zweite Stromspiegelschaltung, bestehend aus einem siebten und achten Transistor T7, T8, an Bezugspotential 10 geschaltet sind; und

wobei die erste Ausgangsklemme 3 des Doppeldifferenzverstärkers DD mit dem Kollektoranschluß des zweiten pnp-Transistors T2 und die zweite Ausgangsklemme 4 des Doppeldifferenzverstärkers DD mit dem Kollektoranschluß des vierten Transistors T4 verbunden ist.

Die erste Stromspiegelschaltung weist als fünften Transistor T5 und sechsten Transistor T6 jeweils npn-Transistoren auf, wobei der fünfte Transistor T5 als Diode geschaltet ist. Dies erfolgt dadurch, daß dessen Kollektoranschluß und Basisanschluß miteinander verbunden sind. Der Emitteranschluß dieses fünften Transistors T5 ist zusätzlich mit dem Kollektoranschluß des ersten Transistors T1 in Verbindung, während der Emitteranschluß an Bezugspotential 10 und der Basisanschluß mit dem Basisanschluß des sechsten Transistors T6 geschaltet ist. Der Emitteranschluß dieses sechsten Transistors liegt auf Bezugspotential 10, während dessen Kollektoranschluß mit dem Kollektoranschluß des vierten Transistors in Verbindung steht.

Die zweite Stromspiegelschaltung ist analog aufgebaut. Im Ausführungsbeispiel von FIG 2 ist der achte Transistor T8, der an den Kollektoranschluß des dritten Transistors T3 geschaltet ist, als Diode verschaltet.

Wie in FIG 2 im einzelnen dargestellt ist, weist der in FIG 1 gezeigte Operationsverstärker OP einen Differenzverstärker mit zwei npn-Transistoren T12 und T13 auf, die mit ihren Emitteranschlüssen über eine zweite Stromquelle Iq2 an Bezugspotential 10 geschaltet sind. Der Basisanschluß des zwölften Transistors T12 stellt dabei den invertierenden Eingang 5 des Operationsverstärkers OP und der Basisanschluß des dreizehnten Transistors T13 den nicht invertierenden Eingang des Operationsverstärkers OP dar. Der Operationsverstärker OP verfügt darüberhinaus über einen Stromspiegel, der aus dem als Diode geschalteten neunten Transistor T9 und einem zehnten Transistor T10 gebildet ist. Der neunte Transistor T9 und zehnte Transistor T10 sind dabei pnp-Transistoren, deren Emitteranschlüsse mit der Versorgungsspannung Us in Verbindung stehen und deren Basisanschlüsse miteinander verbunden sind. Der Kollektoranschluß des neunten Transistors T9 ist einerseits mit dem Kollektoranschluß des zwölften Transistors T12 des im Operationsverstärker OP vorgesehenen Differenzverstärkers und andererseits mit seinem eigenen Basisanschluß verbunden. Der Kollektoranschluß des zehnten Transistors T10 ist mit dem Kollektoranschluß des dreizehnten Transistors T13 in Verbindung.

Ausgangsseitig weist der Operationsverstärker OP einen Emitterfolger in Form eines elften Transistors T11 auf, der ein npn-Transistor ist, und dessen Basisanschluß mit dem Kollektoranschluß des dreizehnten Transistors T13 verbunden ist. Der Kollektoranschluß des elften Transistors T11 ist mit der Vorsorgungsspannung Us in Verbindung. Der Emitteranschluß des elften Transistors T11 ist zugleich der Ausgang 7 des Operationsverstärkers und damit mit dem Ausgangsanschluß 8 der erfindungsgemäßen Schaltungsanordnung und auch über dem zum Lastwiderstand RL identischen Widerstand RL an den invertierenden Eingang 5 des Operationsverstärkers OP angeschlossen. Der Basisanschluß des elften Transistors TII ist mit dem Kollektoranschluß des zehnten Transistors T10 in Verbindung.

Geht man davon aus, daß kein Gleichtaktstromfehler in der Schaltungsanordnung auftritt, so gelten folgende Gleichungen

$$Ui = 0$$

$$Ua = Ux - Uy$$

$$Iy = - Ix$$

$$Ux = Ix . RL$$

$$Uy = Iy . RL = - Ix . RL$$

$$Ua = Ix . RL . 2,$$

wobei die Ströme Iy und Ix, wie durch die dritte obere Gleichung angegeben, gegenphasig sind und Ux die Spannung am Lastwiderstand RL, der zwischen die zweite Ausgangsklemme 4 des Doppeldifferenzverstärkers DD und den zweiten Ausgangsanschluß 9 der erfindungsgemäßen Schaltungsanordnung angeordnet ist, bezeichnet. Die Spannung Uy bezeichnet die Spannung zwischen dem invertierenden Eingang 5 und dem Ausgang 7 des Operationsverstärkers OP.

Geht man davon aus, daß die erfindungsgemäße Schaltungsanordnung Gleichtaktstromfehler aufweist, so gelten folgende Gleichungen:

$$Ui = 0$$

$$Ua = Ux - Uy$$

$$Ix = Ix^\circ + If$$

$$Iy = Iy^\circ + If$$

$$Iy^\circ = - Ix^\circ$$

$$Iy = - Ix^\circ + If$$

$$Ux = Ix . RL = (Ix^\circ + If) RL$$

$$Uy = Iy . RL = (-Ix^\circ + If) RL$$

$$Ua = (Ix^\circ + If) RL - (-Ix^\circ + If) RL$$

$$Ua = 2 . Ix^\circ . RL,$$

wobei If einen Gleichtaktfehlerstrom und Iy°, Ix° die gegenphasigen Ströme bezeichnet.

In FIG 2 ist zwar eine Ausführungsform mit einem Doppeldifferenzverstärker mit pnp-Transistoren und einem Operationsverstärker OP mit npn-Transistoren beschrieben. Es ist aber auch möglich, daß statt der pnp-Transistoren npn-Transistoren eingesetzt werden und umgekehrt. In diesem Fall müssen selbstverständlich auch die Polaritäten der Spannungen entgegengesetzt werden.

**Patentansprüche**

1. Schaltungsanordnung zum Umformen eines symmetrischen gegenphasigen Eingangssignales (Ue) in ein unsymmetrisches einphasiges Ausgangssignal (Ua) mit:

- einem gepaarten Doppeldifferenzverstärker (DD) mit einer ersten und zweiten Eingangsklemme (1, 2) zum Anlegen des symmetrischen gegenphasigen Eingangssignales (Ue) und einer ersten und zweiten Ausgangsklemme (3, 4), an denen jeweils ein gegenphasiges Stromausgangssignal (Ix, Iy) abgreifbar ist;

- einem Lastwiderstand (RL), der zwischen eine Referenzspannungsquelle (Ur) und die zweite Ausgangsklemme (4) des Doppeldifferenzverstärkers (DD) geschaltet ist;

- einem Operationsverstärker (OP) mit einem invertierenden Eingang (5), einem nicht invertierenden Eingang (6) sowie einem Ausgang (7), wobei der nicht invertierende Eingang (6) mit der zweiten Ausgangsklemme (4) des Doppeldifferenzverstärkers (DD) in Verbindung steht und wobei der invertierende Eingang (5) einerseits mit der ersten Ausgangsklemme (3) des Doppeldifferenzverstärkers (DD) und andererseits über einen weiteren zum Lastwiderstand (RL) identischen Widerstand (RL) mit dem Ausgang (7) des Operationsverstärkers (OP) verbunden ist; und

- einem ersten und zweiten Ausgangsanschluß (8, 9), an denen das unsymmetrische einphasige Ausgangssignal (Ua) abgreifbar ist, wobei der erste Ausgangsanschluß (8) an den Ausgang (7) des Operationsverstärkers (OP) und der zweite Ausgangsanschluß (9) an eine Verbindung des Lastwiderstandes (RL) mit der Referenzspannungsquelle (Ur) angeschlossen ist,

**dadurch gekennzeichnet,**
daß der gepaarte Doppeldifferenzverstärker (DD) aufweist:

- einen ersten Differenzverstärker mit einem ersten und einem vierten pnp-Transistor (T1, T4) mit jeweils einem Emitteranschluß, Basisanschluß und Kollektoranschluß, deren Basisanschlüsse jeweils mit einer der Eingangsklemmen (1, 2) verbunden sind, deren Emitteranschlüsse jeweils über einen ersten und zweiten Widerstand (R1, R2) mit einer Klemme (11) einer ersten Stromquelle (Iql) verbunden sind, deren andere Klemme (12) an eine Versorgungsspannung (Us) geschaltet ist und deren Kollektoranschlüsse über eine erste Stromspiegelschaltung, bestehend aus einem fünften und sechsten Transistor (T5, T6) an Bezugspotential (10) geschaltet sind;

- einem zweiten Differenzverstärker mit einem zweiten und dritten pnp-Transistor (T2, T3) mit jeweils einem Emitteranschluß, Basisanschluß und Kollektoranschluß, deren Basisanschlüsse jeweils mit einer der Eingangsklemmen (1, 2) verbunden sind, deren Emitteranschlüsse mit jeweils einem der Emitteranschlüsse des ersten und vierten pnp-Transistors (T1, T4) des ersten Differenzverstärkers verbunden sind und deren Kollektoranschlüsse über eine zweite Stromspiegelschaltung, bestehend aus einem siebten und achten Transistor (T7, T8), an Bezugspotential (10) geschaltet sind; und

daß die erste Ausgangsklemme (3) des Doppeldifferenzverstärkers (DD) mit dem Kollektoranschluß des zweiten pnp-Transistors (T2) und die zweite Ausgangsklemme (4) des Doppeldifferenzverstärkers (DD) mit dem Kollektoranschluß des vierten Transistors (T4) verbunden ist.

2. Schaltungsanordnung nach Anspruch 1,
   **dadurch gekennzeichnet,**
   daß der Operationsverstärker (OP) eingangsseitig einen Differenzverstärker (T12, T13) aufweist, der über einen Stromspiegel (T9, T10) mit Strom beaufschlagt und ausgangsseitig mit einem Emitterfolger (TII) verbunden ist.

3. Schaltungsanordnung nach Anspruch 2,
   **dadurch gekennzeichnet,**
   daß der erste und zweite Differenzverstärker des gepaarten Doppeldifferenzverstärkers (DD) als ersten, zweiten, dritten und vierten Transistor (T1, T2, T3 und T4) jeweils npn-Transistoren und der Differenzverstärker (T12, T13) des Operationsverstärkers (OP) als Transistoren pnp-Transistoren aufweist.

4. Schaltungsanordnung nach Anspruch 2,
   **dadurch gekennzeichnet,**
   daß der erste und zweite Differenzverstärker des gepaarten Doppeldifferenzverstärkers (DD) als ersten, zweiten, dritten und vierten Transistor (T1, T2, T3 und T4) jeweils pnp Transistoren und der Differenzverstärker (T12, T13) des Operationsverstärkers (OP) als Transistoren npn-Transistoren aufweist.

**Claims**

1. Circuit arrangement for converting a balanced, in-antiphase input signal (Ue) into an unbalanced, single-phase output signal (Ua), having:

   - a paired double differential amplifier (DD) having a first and a second input terminal (1, 2) for the application of the balanced, in-antiphase input signal (Ue) and having a first and a second output terminal (3, 4), at which it is possible to pick off a respective in-antiphase current output signal (Ix, Iy);

   - a load resistor (RL), which is connected between a reference voltage source (Ur) and the second output terminal (4) of the double differential amplifier (DD);

   - an operational amplifier (OP) having an inverting input (5), a non-inverting input (6) as well as an output (7), the non-inverting input (6) being connected to the second output terminal (4) of the double differential amplifier (DD) , and the inverting input (5) being connected, on the one hand, to the first output terminal (3) of the double differential amplifier (DD) and, on the other hand, via a further resistor (RL) which is identical to the load resistor (RL), to the output (7) of the operational amplifier (OP); and

- a first and a second output terminal (8, 9), at which it is possible to pick off the unbalanced, single-phase output signal (Ua), the first output terminal (8) being connected to the output (7) of the operational amplifier (OP), and the second output terminal (9) being connected to a connection of the load resistor (RL) to the reference voltage source (Ur),

characterized in that the paired double differential amplifier (DD) has:

- a first differential amplifier having a first and a fourth pnp transistor (T1, T4) each having an emitter terminal, base terminal and collector terminal, the base terminals thereof each being connected to one of the input terminals (1, 2), the emitter terminals thereof being respectively connected via a first and a second resistor (R1, R2) to a terminal (11) of a first current source (Iq1), the other terminal (12) of which is connected to a supply voltage (Us), and the collector terminals thereof being connected to reference-earth potential (10) via a first current mirror circuit, comprising a fifth and a sixth transistor (T5, T6);
- a second differential amplifier having a second and a third pnp transistor (T2, T3) each having an emitter terminal, base terminal and collector terminal, the base terminals thereof each being connected to one of the input terminals (1, 2), the emitter terminals thereof being connected to in each case one of the emitter terminals of the first and fourth pnp transistors (T1, T4) of the first differential amplifier and the collector terminals thereof being connected to reference-earth potential (10) via a second current mirror circuit, comprising a seventh and an eighth transistor (T7, T8) ; and

in that the first output terminal (3) of the double differential amplifier (DD) is connected to the collector terminal of the second pnp transistor (T2) and the second output terminal (4) of the double differential amplifier (DD) is connected to the collector terminal of the fourth transistor (T4).

2. Circuit arrangement according to Claim 1, characterized in that the operational amplifier (OP) has, on the input side, a differential amplifier (T12, T13) which has current applied to it via a current mirror (T9, T10) and, on the output side, is connected to an emitter follower (T11).

3. Circuit arrangement according to Claim 2, characterized in that the first and second differential amplifiers of the paired double differential amplifier (DD) in each case have npn transistors as the first, second, third and fourth transistors (T1, T2, T3 and T4), and the differential amplifier (T12, T13) of the operational amplifier (OP) has pnp transistors as transistors.

4. Circuit arrangement according to Claim - 2, characterized in that the first and second differential amplifiers of the paired double differential amplifier (DD) in each case have pnp transistors as the first, second, third and fourth transistors (T1, T2, T3 and T4), and the differential amplifier (T12, T13) of the operational amplifier (OP) has npn transistors as transistors.

**Revendications**

1. Agencement de circuits pour transformer un signal d'entrée symétrique en opposition de phase $(U_e)$ en un signal de sortie asymétrique monophasé $(U_a)$ avec:

- un amplificateur différentiateur double accouplé (DD) avec une première et une deuxième bome d'entrée (1, 2) pour appliquer le signal d'entrée symétrique en opposition de phase $(U_e)$ et une première et deuxième borne de sortie (3, 4) sur chacune desquelles on peut prélever respectivement un signal de courant de sortie en opposition de phase $(I_x, I_y)$;
- une résistance de charge $(R_L)$ qui est raccordée entre une source de tension de référence $(U_r)$ et la deuxième borne de sortie (4) de l'amplificateur différentiateur double (DD);
- un amplificateur opérationnel (OP) avec une entrée inverseuse (5), une entrée non inverseuse (6), ainsi qu'une sortie (7), l'entrée non inverseuse (6) étant en liaison avec la deuxième bome de sortie (4) de l'amplificateur différentiateur double (DD) et l'entrée inverseuse (5) étant reliée, d'une part, à la première borne de sortie (3) de l'amplificateur différentiateur double (DD) et, d'autre part, à travers une autre résistance $(R_L)$ identique à la résistance de charge $(R_L)$, à la sortie (7) de l'amplificateur opérationnel (OP); et
- une première et une deuxième borne de sortie (8, 9) sur lesquelles on peut prélever le signal de sortie asymétrique monophasé ($U_a$), la première borne de sortie (8) étant raccordée à la sortie (7) de l'amplificateur opérationnel (OP) et la deuxième borne de sortie (9) étant raccordée à un point commun entre la résistance de charge ($R_L$) et la source de tension de référence ($U_r$)

**caractérisée**

par le fait que l'amplificateur différentiateur double accouplé (DD) comporte:

- un premier amplificateur différentiateur avec un premier et un quatrième transistor pnp (T1, T4) avec chacun une bome d'émetteur, une borne de base et une borne de collecteur, leurs bornes de base étant reliées respectivement à une des bomes d'entrée (1, 2), leurs bomes d'émetteur étant reliées respectivement, à travers une première et une deuxième résistance (R1, R2), à une bome (11) d'une première source de courant (Iq1), dont la deuxième bome (12) est raccordée à une tension d'alimentation ($U_s$), et leurs bornes de collecteur étant raccordées, à travers un premier circuit miroir de courant comprenant un cinquième et un sixième transistor (T5, T6) au potentiel de référence (10);

- un deuxième amplificateur différentiateur avec un deuxième et un troisième transistor pnp (T2, T3) avec chacun une borne d'émetteur, une borne de base et une borne de collecteur, leurs bornes de base étant reliées respectivement à une des bornes d'entrée (1, 2), leurs bomes d'émetteur étant reliées respectivement à une des bornes d'émetteur du premier et du quatrième transistor pnp (T1, T4) du premier amplificateur différentiateur et leurs bomes de collecteur étant raccordées, à travers un deuxième circuit miroir de courant comprenant un septième et un huitième transistor (T5, T6), au potentiel de référence (10),

et par le fait que la première bome de sortie (3) de l'amplificateur différentiateur double (DD) est reliée à la borne de collecteur du deuxième transistor pnp (T2) et que la deuxième borne de sortie (4) de l'amplificateur différentiateur double (DD) est reliée à la bome de collecteur du quatrième transistor (T4).

2. Agencement de circuits conforme à la revendication 1
**caractérisée**
par le fait que l'amplificateur opérationnel (OP) comporte, du côté entrée, un amplificateur différentiateur (T12, T13) sur lequel un courant est appliqué à travers un miroir de courant (T9, T10) et est relié, du côté sortie, à un émetteur suiveur (T11).

3. Agencement de circuits conforme à la revendication 2
**caractérisée**
par le fait que le premier et le deuxième amplificateur différentiateur double accouplé (DD) comporte respectivement comme premier, deuxième, troisième et quatrième transistor (T1, T2, T3 et T4) des transistors npn et que l'amplificateur différentiateur (T12, T13) de l'amplificateur opérationnel (OP) comporte comme transistors des transistors pnp.

4. Agencement de circuits conforme à la revendication 2
**caractérisée**
par le fait que le premier et le deuxième amplificateur différentiateur de l'amplificateur différentiateur double accouplé (DD) comporte respectivement comme premier, deuxième, troisième et quatrième transistor (T1, T2, T3 et T4) des transistors pnp et que l'amplificateur différentiateur de l'amplificateur opérationnel (OP) comporte comme transistors des transistors npn.

FIG 1

FIG 2